# EUROPEAN PATENT APPLICATION

(11) **EP 0 856 740 A1**
(43) Date of publication of application: **05.08.1998**
(21) Application number: 98100738.8
(22) Date of filing: 16.01.1998
(51) Int. Cl.: G01R 31/28, G01R 1/073

(54) **PCB testing system**

(30) Priority: 27.01.1997 KR 9702901
(71) Applicant: Kang, Jeung-Gun, Gumi-City, Kyungbuk (KR)
(72) Inventor: Kang, Jeung-Gun, Gumi-City, Kyungbuk (KR)
(74) Representative: TER MEER STEINMEISTER & PARTNER GbR

(57) **Abstract**

Disclosed is a PCB testing system capable of compatibly testing various types of PCBs. To compatibly test various types of the PCBs (3) by means of a single testing system, a probe (2) on which a variable fixing means (A) is attached is individually formed in contact with a testing point of the PCB so that the probe (2) can be moved and rearranged on a base (4).

## Description

### BACKGROUND OF THE INVENTION

### Field of the Invention

The present invention relates to a printed circuit board (PCB) testing system, and more particularly, to a PCB testing system capable of compatibly testing various types of PCBs.

### Discussion of the Related Art

Generally, in a PCB testing system, a plurality of probes having springs corresponding to each of testing points TP of the PCB are fixably mounted on a base. In most of factories which manufacture electronic products, the operation of a PCB into which components are inserted is tested before assembled to a case of the electronic product. In this respect, a private PCB testing system suitable for each model of PCBs has been widely used.

However, such a PCB testing system has several problems.

First, the PCB testing system has no compatibility with other system. That is, since the PCB testing system must be newly manufactured whenever a model of the product is changed, the cost is increased and loss of time is caused in separately manufacturing a private PCB testing system. Particularly, in case of in-line system capable of manufacturing various types, line must partially be changed whenever the model of the PCB is changed, thereby causing limitation in automatic system.

### SUMMARY OF THE INVENTION

Accordingly, the present invention is directed to a PCB testing system that substantially obviates one or more of the problems due to limitations and disadvantages of the related art.

An object of the present invention is to provide a PCB testing system in which the position of a probe can simply be changed to correspond to the PCB whenever a model of the PCB is changed so as to improve operation efficiency and provide compatibility of the system.

Another object of the present invention is to provide a PCB testing system which enables in-line automatic system, manufacture of various types of PCBs, and remote control test.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
Fig. 1 is a brief perspective view illustrating a PCB testing system according to the preferred embodiment of the present invention; and
Fig. 2 is a front plan view illustrating partial cut state of a probe as a subject element of a PCB testing system according to the present invention.

### DETAILED DESCRIPTION OF THE PREFERRED EMBODIMENTS

Reference will now be made in detail to the preferred embodiments of the present invention, examples of which are illustrated in the accompanying drawings.

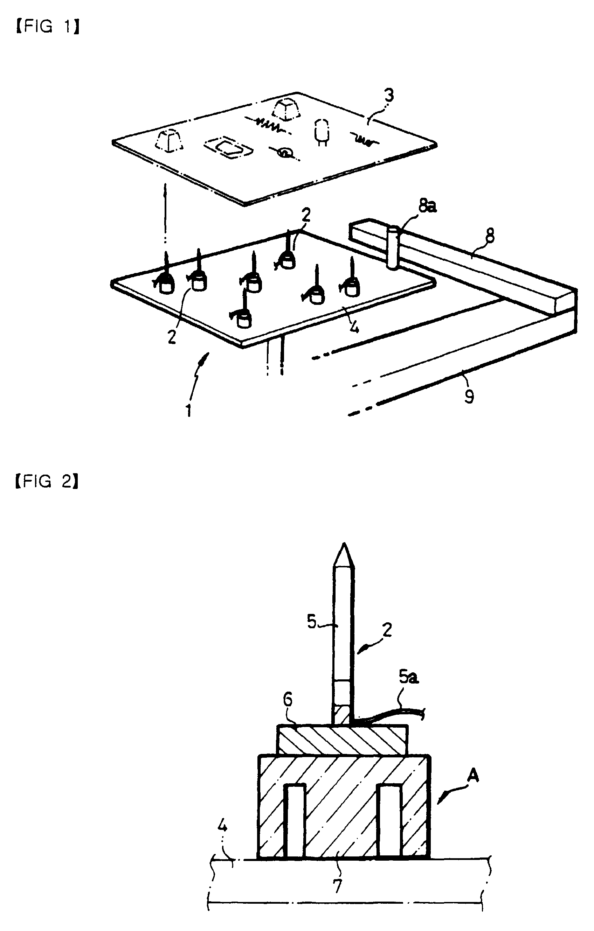

Fig. 1 is a brief perspective view illustrating a PCB testing system 1 according to the preferred embodiment of the present invention. Fig. 2 is a front plan view illustrating partial cut state of a probe 2 as a subject element of a PCB testing system according to the present invention.

In the PCB testing system 1 of the present invention, a probe 2 is selectively up and down in vertical direction below a pattern of a PCB 3 to connect a signal generated in the PCB 3 with a testing system. The PCB testing system 1 of the present invention facilitates test of various types of PCBs.

In the present invention, the probe 2 is individually formed separated from a base 4. That is, as shown in Fig. 2, the base 4 is made of a metal plate on which a magnetic substance can be attached and separated from. On an upper portion of the base 4, the probe 2 is mounted to be moved to a predetermined position as occasion demands. A variable fixing means A is mounted on a lower portion of a probe pin 5. The variable fixing means A is formed in an integral form with a magnet 7 which is covered by an insulator 6. A cord 5a is connected with a lower portion of the probe pin 5 to be connected to the testing system.

Either an electro magnet or a permanent magnet can be used as the magnet 7 as occasion demands. In the same manner, the base 4 may be replaced with the electro magnet or the permanent magnet to correspond to the probe 2.

Alternatively, the magnet 7 may be replaced with a vacuum pad (not shown). That is, the vacuum pad may be attached on the lower portion of the probe 2. The base 4 is formed of a porous plate to variably move the vacuum pad in a predetermined position on the base 4 by means of a vacuum adsorber.

In the PCB testing system 1 of the present invention, a PCB of a specific model is registered in a testing program by inputting X and Y coordinates. Art work drawing of the PCB is then input and a testing point is selected to completely register the designated PCB so that the PCB test can be carried out. To change the PCB model, if the changed PCB model is selected, the base 4 is descended and the probe 2 is clamped to a robot hand 8a of robot arms 8 and 9. Subsequently, the probe 2 is moved to a set position and then unclamped to be rearranged on a testing point of the changed PCB model. Since the robot arms 8 and 9 and the robot hand 8a which enable software for the PCB test and the probe 2 to be moved and rearranged are general elements, their detailed description will be omitted.

The aforementioned PCB testing system of the present invention is used for in testing whether or not the PCB 3 for various electronic products is normally operated before assembled to a case of the electronic product. The testing point of the PCB and the number of the testing point depend on each model of the PCBs.

In case of the conventional PCB testing system, private PCB testing system must separately be manufactured whenever the PCB model is changed. However, in the PCB testing system of the present invention, since the probe 2 which contacts with the testing point of the PCB is individually moved from the base 4, the probe 2 is moved to the testing point set by the robot arms 8 and 9 and the robot hand 8a, by registering a new model of the PCB when changing a model of the PCB to the new model of the PCB. This can be achieved by that the probe 2 of the present invention is fixed and moved to a predetermined position of the base 4 at the lower portion of the probe pin 5.

In other words, the lower portion of the probe pin 5 is formed of either the magnet 7 such as the electro magnet or the permanent magnet or the variable fixing means A such as the vacuum pad. The base 4 corresponding to the lower portion of the probe pin 5 is formed of either a metal plate on which the magnetic substance is attached and separated from or the porous plate connected with the magnetic substance or the vacuum adsorber. Therefore, the robot hand 8a of the robot arms 8 and 9 clamp the probe 2 to simply move the probe 2 to the changed testing point so that the probe 2 can be rearranged. After changing the position of the probe 2, the probe 2 is maintained at its position by itself or by means of adsorption of the vacuum adsorber so that the changed PCB model can promptly, exactly be tested.

As aforementioned, the PCB testing system of the present invention has the following advantages.

Unlike the conventional PCB testing system which respectively corresponds to each model of the various PCBs and changes the device in-line system one by one, in the PCB testing system of the present invention, the position of the probe 2 can simply be changed to be suitable for the selected PCB model by remote control through the computer.

The PCB testing system of the present invention can be almost applied to all types of the PCBs and is remote controlled. Further, since one PCB testing system can test various types of the PCBs, separate testing devices are not required, thereby reducing the manufacturing costs and improving compatibility in operation efficiency.

It will be apparent to those skilled in the art that various modifications and variations can be made in the PCB testing system according to the present invention without departing from the spirit or scope of the invention. Thus, it is intended that the present invention covers the modifications and variations of the invention provided they come within the scope of the appended claims and their equivalents.

## Claims

1. A PCB testing system (1) for testing various types of PCBs is characterized in that a probe (2) having a probe pin (5) is individually formed separated from a base (4), the probe pin (5) being in contact with a testing point of the PCB, and a variable fixing means (A) is attached on a lower portion of the probe (2) to be fixed and moved to a predetermined position on the base (4) by a coordinate set by a robot hand (8a) when changing a type of the PCB.

2. The PCB testing system as claimed in claim 1, wherein the variable fixing means (A) attached on the lower portion of the probe (2) is a magnetic substance.

3. The PCB testing system as claimed in claim 1, wherein the variable fixing means (A) attached on the lower portion of the probe (2) is a vacuum pad.

4. The PCB testing system as claimed in claim 1, wherein the base (4) is a magnetic substance.

5. The PCB testing system as claimed in claim 1, wherein the base (4) is formed of a porous plate and connected to a vacuum adsorber so as to variably fixing the variable fixing means (A) made of the vacuum pad.
